# EUROPÄISCHE PATENTSCHRIFT

(11) **EP 2 576 481 B1**
(45) Veröffentlichungstag und Bekanntmachung des Hinweises auf die Patenterteilung: **16.12.2015**
(21) Anmeldenummer: 11727656.8
(22) Anmeldetag: 24.05.2011
(51) Int. Cl.: B05D 3/06, C04B 35/468, C04B 35/491, C04B 35/626, C08F 20/06, C09D 4/00, C23C 18/06, C23C 18/12, C23C 18/14, H01L 41/18, H01L 41/187, H01L 41/318, H01L 41/331

(54) **STRUKTURIERTE SCHICHTEN AUS VERNETZTEN ODER VERNETZBAREN METALLORGANISCHEN VERBINDUNGEN, DIESE ENTHALTENDE GEFORMTE KÖRPER, SOWIE DEREN HERSTELLUNGSVERFAHREN**
STRUCTURED LAYERS OF CROSSLINKED OR CROSSLINKABLE ORGANOMETALLIC COMPOUNDS, FORMED OBJECTS COMPRISING SAID LAYERS AND METHODS TO PRODUCE THEM
REVÊTEMENTS STRUCTURÉS A BASE DE COMPOSÉS RETICULÉS OU RÉTICULABLES, OBJÉTS MOULÉS COMPRENANTS CES REVÊTEMENTS ET SON PROCÉDÉ DE PRODUCTION

(30) Priorität: 25.05.2010 DE 102010021466
(43) Veröffentlichungstag der Anmeldung: 10.04.2013
(73) Patentinhaber: Fraunhofer-Gesellschaft zur Förderung der angewandten Forschung e.V., 80686 München (DE)
(72) Erfinder: HOUBERTZ-KRAUSS, Ruth, 97074 Würzburg (DE); TRÖTSCHEL, Daniela, 97440 Werneck (DE)
(74) Vertreter: Olgemöller, Luitgard Maria
(86) Internationale Anmeldenummer: PCT/EP2011/058512
(87) Internationale Veröffentlichungsnummer: WO 2011/147854

(56) Entgegenhaltungen:
- DE-A1-102004 061 324
- US-B1- 6 291 070
- MEI ZHANG ET AL: "GC-MS and 13 C NMR Investigation of Lead Zirconate Titanate Precursor Sols for Fiber Preparation", JOURNAL OF THE AMERICAN CERAMIC SOCIETY, Bd. 90, Nr. 2, 1. Februar 2007 (2007-02-01), Seiten 358-363, XP55005248, ISSN: 0002-7820, DOI: 10.1111/j.1551-2916.2006.01347.x

## Beschreibung

Die vorliegende Erfindung beschäftigt sich mit der Herstellung strukturierter Formkörper sowie dünner oder auch dickerer Schichten aus auf photochemischem Wege organisch vernetzbaren metallorganischen Verbindungen, aus denen sich durch Sinterung und ggf. nachfolgende physikalische Aktivierung, beispielsweise Polarisation mit Hilfe eines elektrischen Feldes oder, falls magnetische Materialien darin enthalten sind, Aktivierung durch ein Magnetfeld, technisch relevante oxidische Funktionskörper oder -schichten herstellen lassen, z.B. in Form von magnetisch oder piezoelektrisch aktiven Sensoren oder Aktoren oder (Energie-)Wandlern wie Ultraschallwandlern aus PZT (Blei-Zirkonat-Titanat) oder BTO (Bariumtitanat). Die Erfindung stellt ein Verfahren zum Herstellen solcher Körper oder Schichten sowie ein darauf aufbauendes Verfahren zum Herstellen der funktionellen, oxidischen Körper oder Schichten bereit.

Piezoelektrisch aktive Materialien werden z.B. als Aktoren oder Sensoren eingesetzt, u.a. in der Ultraschalltechnik. Aufgrund des allgemeinen Trends hin zu kleineren, kostengünstigen und dennoch leistungsstärkeren Elektroniken besteht ein erhöhtes Interesse an Ultraschall-Arrays aus piezoaktiven Materialien mit besonders kleinen, lateralen Ausdehnungen, z.B. in der Medizin (siehe I.R.S. Makin et al., Med. Biol. (2005) 31, 1539-1550) oder der zerstörungsfreien Materialprüfung (S.D. Song et al., Nucl. Eng. Des. (2002) 214, 151-161). Unter Ultraschall-Arrays versteht man dabei Gruppenstrahler, die aus vielen kleinen Einzelstrahlern bestehen (B. Waldron, G. Kauth, Ultraschall-Array-Technik für industrielle Anwendungen, ZfP-Zeitung (2000) 69, 50-52). Diese Gruppenstrahler können durch geeignetes Bearbeiten eines großen Strahlers hergestellt werden. Bei diesen Arrays wird es möglich, bei höheren Arbeitsfrequenzen genauere und hochauflösende Diagnosen in verschiedenen medizinischen Bereichen, z.B. der Ophthalmologie, der Dermatologie und der Gefäßwanddiagnostik, zu erhalten. PZT eignet sich dabei aufgrund seiner hohen piezoelektrischen Koeffizienten sehr gut als Material für die Hochleistungs-Arrays. Auch BTO besitzt hinreichend hohe piezoelektrische Koeffizienten für diese Anwendungen.

Die Darstellungsmöglichkeiten von PZT- und BTO-Dünnschichten reichen ganz allgemein von chemischen und physikalischen Gasphasenabscheidungen (CVD und PVD) bis hin zu nasschemischen Verfahren (Sol-Gel Chemie) (M. de Keijser et al., J. Appl. Phys. (1996) 79, 393-402; T.-L. Ren et al., Mater. Sci. Eng. B (2003) 99, 159-163 ; R.W. Schwartz et al., Chem. Mater. (1997) 9, 2325-2340; C.J. Brinker, G.W. Scherrer, Verfahren gegenüber den Gasphasenabscheidungen zählen die kostengünstigeren Reaktionsaufbauten und eine einfachere Reaktionsführung. Des Weiteren ist die Sol-Gel-Chemie nicht auf Substrate angewiesen, und es können unter anderem Formkörper und auch Fasern hergestellt werden. In DE 43 32 831 C1 sind Verfahren zur Herstellung von PZT-Solen und den dazugehörigen Formkörpern auf PZT-Basis beschrieben. Dabei werden kommerziell erhältliche Titan- und Zirconiumorganyle nach einer Alkoholyse mit Carbonsäuren versetzt, um die Precursoren gegenüber H₂O und O₂ zu stabilisieren. Das nach der Vereinigung mit der Blei-Komponente erhaltene, stabilisierte Sol wird anschließend durch die Entfernung der flüchtigen Bestandteile verfestigt, um es dann für den Formgebungsprozess nach erneutem Aufschmelzen für Fasern, Beschichtungen oder Formkörper zu verwenden.

Aus dem Artikel von Mei Zhang et al. "GC-MS and 13-C-NMR Investigation of Lead Zirconate Titanate Procursor Sols for Fiber Preparation" im Journal of the American Ceramic Society, Bd. 90(2), 358-363 (2007) sind PZT-Fasern bekannt, die über das Sol-Gel-Verfahren hergestellt und durch Ziehen geformt wurden. Hierfür dienten Titanisopropoxid, Zirkoniumpropoxid und Bleiacetat-Trihydrat als Ausgangsmaterialien, die zur Herstellung eines Sols in Isopropanol gelöst wurden. Die Hydrolyse erfolgte entweder in reinem destilliertem Wasser oder einer Mischung aus Wasser und entweder Essigsäure oder Methacrylsäure.

Die Strukturierung von PZT-Schichten kann grundsätzlich entweder mit der Schichtbildung kombiniert oder im Anschluss daran durchgeführt werden. Beispiele für die direkte Strukturierung sind das Drucken eines PZT-Precursor-Sols mittels Thermal Ink Jet Printing (S. Bathurst et al., IEEE/MEMS (Tucson) (2008), 391-394; das eingesetzte Sol wurde gewonnen durch Verdünnen eines kommerziellen, 2-Methoxyethanol enthaltendenden Sols mit Isopropylalkohol und 2-Ethylhexansäure) oder die Nano-Imprint-Lithographie (D. Hesse et al., Nanoimprint-Lithographie für oxidische Funktionsmaterialien, Abschlussbericht zum BMBF-Vorhaben 13N7986). Für die Letztere untersuchten die Autoren zwei verschiedene Typen der chemischen Lösungsabscheidung, nämlich die metallorganische Abscheidung (MOD) unter Verwendung kommerziell erhältlicher metallorganischer Vorstufen, wie Titanisopropoxid oder Zirconium-n-propoxid, und wasserabweisender Lösungsmittel, sowie das - dem erstem Abscheidungstyp überlegene - Sol-Gel-Verfahren, bei dem ausgehend von fließfähigen, ebenfalls kommerziell erhältlichen Solen über eine Hydrolyse mit Luftfeuchtigkeit ein relativ hochviskoses Gel für die zu prägende Precursorschicht verwendet wurde. Möglichkeiten für die nachträgliche Strukturierung sind Trockenätzverfahren, wie RIE (Reactive Ion Etching), bei dem die PZT-Schicht durch gezielten Beschuss mit geladenen Gasen, die in einem Plasma erzeugt werden, abgetragen werden. Des Weiteren konnten PZT-Schichten mit elektronen- und ionenstrahlgestützten Methoden, wie Electron Beam Direct Writing und Focussed Ion Beam Etching, strukturiert werden. Gemäß DE 38 35 794 A1 lassen sich strukturierte PZT-Schichten zudem dadurch erhalten, dass man die aufgebrachte PZT-Dünnschicht gezielt mit Hilfe von Laserlicht (ablativ) abträgt.

Darüber hinaus wurden strukturierte PZT-Schichten mit Hilfe der Lift-Off-Methode hergestellt (siehe H.-J. Zhao et al., Fabrication of High Quality PZT Thick Film Using Lift-Off Technique, Nanotech. (2003), 1. ISBN 0-9728422-0-9). Hierbei wird zunächst eine strukturierbare Photoresist-Schicht auf das Substrat aufgetragen, die dann nach der PZT-Beschichtung mit Hilfe von Lösemitteln zusammen mit dem PZT-Material, das direkt auf das Photoresist aufgebracht wurde, entfernt wird. Dieses Verfahren besitzt den Nachteil, dass eine Vielzahl von Reaktionsschritten erforderlich ist: Zuerst muss eine Photoresist-Schicht aufgebracht und strukturiert werden; der unbelichtete Rest der Photoresist-Schicht muss entfernt werden, das PZT-Sol muss aufgebracht, getrocknet und vorgesintert werden, die Photoresist-Schicht und die darauf liegende PZT-Schicht müssen wiederum entfernt werden, und schließlich muss die verbliebene strukturierte PZT-Schicht gesintert werden.

Über eine wärmekontrollierte Strukturierungsmethode zur Herstellung strukturierter BTO-Schichten berichten T. Watanabe et al. in Thin Solid Films (2006), 515, 2692-2699. Sie fokussierten einen Laserstrahl auf eine wässrige Ba²⁺-Lösung auf einem Titanmetallsubstrat und induzierten damit eine direkte Kristallisation des BTO. Dieser Strukturierung liegt keine Photoreaktion zugrunde. Vielmehr resultieren die lokale Erhöhung der Temperatur und die Entstehung extremer Bedingungen in einer hydrothermalen Reaktion. Dies ist unter anderem durch die Verbreiterung der strukturierten Bereiche im Vergleich zur lateralen Ausdehnung des Laserstrahls zu erkennen. Ein weiterer Nachteil dieser Methode ist die zwingende Beschränkung auf Titanmetall als Substrat, da dieses auch die alleinige Titan-Quelle bildet.

Eine photochemische, direkte Strukturierung von photosensitiven PZT-Gelen wurde unter anderem von N. Tohge et al. in J. Mater. Sci. - Mater. Electron. (1999) 10, 273-277 beschrieben. Die Autoren stabilisierten die hydrolyseempfindlichen PZT-Precursoren mit β-Diketonen. Die dadurch entstehenden Chelatkomplexe besitzen eine Absorptionsbande für den π-π*-Übergang im UV-Bereich (bei etwa 360nm für Chelate mit Benzoylaceton). Bei Belichtung mit den entsprechenden Wellenlängen werden diese Chelatkomplexe gespalten, was zu einer veränderten Löslichkeit der bestrahlten Precursoren-Bereiche in sauren und alkoholischen Medien führt. Dies wiederum wird dafür ausgenutzt, die unbestrahlten Bereiche selektiv aus den Schichten herauszulösen, wofür zum einen wässrige methanolische und zum anderen salpetersaure Lösungsmittel verwendet wurden. Laut den Autoren sind Strukturen bis in den Bereich von ca. 5 µm darstellbar. Diese Strukturierungsmethode ist ebenfalls für andere oxidische Materialien, u.a. ZrO und Strontium-dotiertes BTO, geeignet (K. Shinmou et al., Jpn. J. Appl. Phys. (1994), 33, L1181-L1184; Z. Weihua et al., Chinese Journal of Semiconductors (2006) 27, 1590-1594). Die Zerstörung der Komplexe durch Bestrahlen bewirkt jedoch, dass Nebenprodukte im bestrahlten Bereich entstehen, was von Nachteil ist. Auch hat die Zerstörung von Liganden in unmittelbarer Nähe der sie bindenden Metallkationen zur Folge, dass die durch das Gel zuvor stabilisierte Anordnung der einzelnen Komponenten zueinander und damit deren für die spätere Kristallbildung wichtige homogene Verteilung destabilisiert wird. Außerdem sind die der Löslichkeitsänderung zugrundeliegenden chemischen Mechanismen dieses Verfahrens nicht bekannt, weshalb eine Standardisierung schwierig ist.

Die meisten der vorgenannten Verfahren haben außerdem den Nachteil, dass die PZT-Materialien, die für das Aufbringen der Beschichtungen verwendet werden, nicht langfristig stabil sind, sondern der Gefahr der Entmischung der einzelnen Komponenten unterliegen. Diese Gefahr besteht nur dann nicht, wenn die aufzubringenden Materialien in Form eines Sols vorliegen, in dem die einzelnen Metallatome auf molekularer Ebene statistisch verteilt bereits vorfixiert sind bzw. wenn die Lage der Komponenten dieses Sol bei der Strukturierung nicht grundlegend gestört wird.

Die voranstehend erläuterten Nachteile und Probleme bei der Herstellung strukturierter piezoelektrischer Schichten über strukturierbare Precursorenschichten sind natürlich nicht auf die dort genannten spezifischen Materialien beschränkt, sondern sie treten bei der Herstellung auch anderer oxidischer Schichten auf, die über komplexierbare/komplexierte Precursoren hergestellt werden müssen oder können.

Nun bestehen die eingangs genannten Ultraschall-Arrays zwar häufig aus "eindimensionalen", d.h. dünnen, streifenförmigen Schichten, oder "zweidimensionalen" Strukturen, nämlich dünnen, rechteckigen "Feldern". Die Ausdehnung der Letzteren wird häufig als 2,5-D bezeichnet. Sie können aus einem Komposit bestehen, das eine (aktive) piezoelektrische Phase und eine (inaktive) Polymerphase enthält. Zunehmend werden Ultraschall-Arrays aber in Form von sogenannten 1-3-Kompositen hergestellt. Dabei liegt das dreidimensional strukturierte piezoelektrisch aktive Material in Form von Stäbchen, Säulen oder Fasern vor. Nach der sog. "Pick-And-Place"-Methode werden diese hergestellt, indem einzelne zuvor hergestellte Stäbchen oder Fasern im Polymer, z.B. einem gewebten Glasgewebe, positioniert werden können (siehe V.F. Janas und Ahmad Safari, "Overview of Fine-Scale Piezoelectric Ceramic/Polymer Composite Processing", J. Am. Ceram. Soc. 78(11), S. 2945-2955 (1995)). Diese Methode ist mit einem hohen Zeitaufwand verbunden, da jedes Stäbchen individuell positioniert werden muss. Alternativ werden 1-3-Komposite heute meist durch die sog. "Dice-And-Place"-Methode hergestellt. Hierbei wird eine piezoelektrische Keramik mittels Diamantsäge rasterförmig eingeschnitten, wodurch viereckige Säulen herausgearbeitet werden. Dabei muss am unteren Ende der Scheibe eine Schicht übrig bleiben, so dass die Struktur stabil bleibt. Um elektrische Störungen zwischen den einzelnen Säulen zu verringern, werden die Zwischenräume mit einem Polymer (meist einem Epoxidharz) ausgefüllt. Nach dem Aushärten wird die stabilisierende Keramikschicht abgeschnitten. Solche piezoelektrischen Ultraschallwandler sind die vielversprechendsten für Bauteile im medizinischen Bereich. Nachteile liegen in der Begrenzung der Dimensionen nach unten, und somit in der Auflösung, durch die Säge und im Zeitaufwand beim Sägen besonders feiner Strukturen. Auch können mit einer Säge nur symmetrische Muster geschnitten werden. Eine Variation dieser Methode ist das Interdigital Pair Bonding, beschrieben von Ruibin Liu et al. (IEEE Transactions on Ultrasonics, Ferroelectrics and Frequency Control 48(1), 299-306 (2001)). Auf diese Weise konnten minimale Abstände von 4 µm erreicht werden. Die Höhe der Säulen lag bei 44 µm und ihre Breite bei 36 µm.

Von Methoden zur Herstellung echter 3-3-Komposite berichten Janas und Safari (a.a.O.) ebenfalls: Zum einen gelingt dies durch das Beschichten eines organischen Schaums mit einem PZT-Schlicker. Nach dem Ausbrennen der Organik bleibt ein dreidimensionales PZT-Gerüst zurück, das anschließend wieder mit einem Polymer gefüllt wird (Reticulation). Zum anderen können PZT-Fasern oder mit PZT-beladenen organischen Fasern verwebt und dann gegebenenfalls noch calciniert werden. Beide Verfahren sind natürlich nicht zur Herstellung exakt vordefinierter Strukturen geeignet.

Echte 3D-Strukturen lassen sich auch mit dem oben beschriebenen Verfahren von Tohge et al. nicht herstellen. Denn durch Bestrahlung gewonnene Körper würden sich aufgrund der Löslichkeitsunterschiede zwar von nicht bestrahltem Material abtrennen lassen; sie bestehen jedoch aus zersetzten Komplexen und können deshalb keine langfristige innere Stabilität aufweisen, wie sie ein diskreter dreidimensionaler, ungestützter oder nur durch eine Substrat gestützter Körper benötigt.

Aufgabe der Erfindung ist es demnach, strukturierte Körper und Schichten, darunter insbesondere Dünnschichten, bereitzustellen, aus denen sich durch Sinterung und ggf. Polarisation oder andere physikalische Schritte oxidische Funktionsschichten oder -körper herstellen lassen, z.B. aus PZT (Blei-Zirkonat-Titanat) oder BTO (Bariumtitanat). Hierfür stellt die Erfindung ein Herstellungsverfahren sowie ein darauf aufbauendes Verfahren zum Herstellen der funktionellen, oxidischen Körper und Schichten bereit. Diese Verfahren sollen die Herstellung von Schichten auf beliebigen, auch unebenen Oberflächen sowie die Herstellung von Formkörpern frei wählbarer Geometrie ermöglichen.

In Lösung dieser Aufgabe beschreibt die Erfindung die Herstellung und Strukturierungspolymerisation von Körpern und Schichten aus einem flüssigen, stabilisierten Precursormaterial (einem "Sol"), das eine oder mehrere mit photochemisch aktiven Gruppen funktionalisierte Organo(übergangs)metallverbindung(en) enthält, wie in den Ansprüchen 1 und 14 definiert. Durch Belichten dieser Körper oder Schichten (bzw. von Teilbereichen davon) mit aktinischer Strahlung geeigneter Wellenlängen werden die photochemisch aktiven Gruppen über eine Additionspolymerisation in ein organisches Netzwerk eingebunden, ohne dass Nebenprodukte entstehen würden. Nicht polymerisiertes Material kann anschließend ausgewaschen werden; die Körper oder Schichten können schließlich durch Sintern in entsprechende, strukturierte Oxidmaterialien überführt werden. Die Metalle der Verbindungen des Precursormaterials sind dabei so gewählt, dass beim Sintern ein in der Regel poly- oder nanokristallines Oxid gebildet wird, das als solches oder nach geeigneter physikalischer Aktivierung die gewünschte Funktion erfüllen kann.

Die für die vorliegende Erfindung geeigneten Oxide sind alle diejenigen, die an Luft entweder als solche oder als Mischoxid stabil sind und deren Kationen sich in Lösung mit geeigneten, sauerstoffhaltigen Anionen/Liganden (insbesondere Alkoholationen, Carboxylationen) halogenidfrei komplexieren lassen bzw. mit ihnen metallorganische Verbindungen bilden, darunter insbesondere Magnesium, Strontium und Barium aus der II. Hauptgruppe, Aluminium, Gallium, und Indium aus der III. Hauptgruppe, Silicium, Zinn und Blei aus der IV. Hauptgruppe sowie die Übergangsmetalle, und unter diesen wiederum insbesondere diejenigen der II., III., IV. und V. Nebengruppe. Ganz besonders bevorzugt sind Aluminiumoxid, Zirkondioxid und die Oxide des Titans, Zirkons, Bleis, Bariums und Strontiums in einer Kombination, die ein piezoelektrisches Verhalten zeigen. Die Erfindung ist jedoch nicht darauf beschränkt, sondern ermöglicht auch beispielsweise die Herstellung von Körpern und Schichten aus PMN (Blei-Magnesium-Niobat) oder Mullit. Oxide des Siliciums sind zumindest als ungemischte Oxide weniger günstig.

Aus bzw. mit diesen Kationen werden erfindungsgemäß mit photochemisch aktiven Gruppen funktionalisierte Organo(übergangs)metallverbindungen gebildet. Diese enthalten komplexierende Liganden/Anionen, die mindestens eine photochemisch polymerisierbare Gruppe und mindestens eine Gruppe aufweisen, die eine stabile Komplexbildung ermöglicht. Bei dieser kann es sich um eine Alkoholatgruppe handeln; bevorzugt sind jedoch Carboxylatgruppen. Die Anionen können gegebenenfalls mehrzähnig (chelatbildend) sein und z.B. weitere Oxo- oder Ketogruppen enthalten. Sie können außerdem ggf. mehr als eine photochemisch polymerisierbare Gruppen aufweisen.

Unter "photochemisch polymerisierbare Gruppe" ist erfindungsgemäß eine Gruppe zu verstehen, die eine oder mehrere reaktionsfähige C=C-Doppelbindungen oder Ringe aufweist, die unter der Einwirkung von aktinischer Strahlung in propagierende Kohlenstoffketten übergehen. Diese Reaktion wird im Englischen als "addition polymerization" oder "chain growth polymerization" bezeichnet. Dabei treten weder Abspaltungen von molekularen Bestandteilen auf, noch Wanderungen oder Umlagerungen. Besonders bevorzugt handelt es sich dabei um eine radikalisch polymerisierbare Gruppe. Die reaktionsfähige(n) Doppelbindung(en) dieser Gruppe kann/können beliebig ausgewählt werden, beispielsweise eine Vinylgruppe oder Bestandteil einer Allyl- oder Styrylgruppe sein. Bevorzugt ist/sind sie Bestandteil einer Doppelbindung, die einer Michael-Addition zugänglich ist, enthält/enthalten also eine infolge der Nachbarschaft zu einer Carbonylgruppe aktivierte Methylengruppe. Unter diesen wiederum besonders bevorzugt sind Acrylat- und Methacrylatguppen. Als Beispiel für reaktionsfähige Ringe seien Epoxid- oder Norbornenringe genannt. Aufgrund der Vielzahl von möglichen polymerisierbaren Gruppen können die Precursoren der Erfindung photochemisch über einen weiten Wellenlängenbereich (vom Angstrom- bis in den µm-Bereich) strukturiert werden. Die Herstellung strukturierter Schichten und insbesondere strukturierter Formkörper aus Metallverbindungen, die ausschließlich Si als Metall enthalten, ist nicht Gegenstand dieser Erfindung.

Die Gruppe, die eine stabile Komplexbildung ermöglicht, kann unter Gruppen ausgewählt werden, die in anionischer Form an das jeweilige Metallatom komplexiert werden, d.h. insbesondere unter Oxogruppen und Carboxygruppen, oder die über den Chelateffekt eine starke Bindung an die jeweiligen Kationen ausbilden. Diese Gruppe(n) müssen nicht notwendigerweise ionisch an das Metallatom binden; sie können auch Atome oder Reste mit freien Elektronenpaaren aufweisen, die über dieses freie Elektronenpaar mehrzähnig binden wie beispielsweise Diketone mit Ketogruppen in 1,3-Stellung zueinander. Das komplexbildende Molekül kann neben einer solchen Gruppe eine oder mehrere weitere Gruppen enthalten, die eine Chelatbildung überhaupt erst oder eine solche mit mehr als zwei Zähnen ermöglicht. Es ist bevorzugt, dass die die stabile Komplexbildung ermöglichende Gruppe über Sauerstoffatome an das Metallatom bindet.

Zwei sehr einfache Moleküle, die sowohl eine Doppelbindung aufweisen als auch eine stabile Komplexbildung ermöglichen und aus diesem Grunde für die Erfindung sehr geeignet sind, sind Acrylsäure und Methacrylsäure. Methacrylsäure ist besonders bevorzugt. Andere Möglichkeiten für geeignete komplexierende Verbindungen sind Acrylsäureester oder Methacrylsäureester oder -amide mit einem freien Carbonsäurerest im Alkohol- oder Amin-Teil des Moleküls, mit einer Allylgruppe substituierte Carbonsäuren oder 1,3-Diketone. Als Beispiele seien 3-Allylacetylaceton und 4-(Methacryloylamino)-benzoesäure genannt.

Das für die Erfindung benötigte Sol wird hergestellt, indem das oder die für das herzustellende reine Oxid oder Mischoxid benötigte(n) Metall(e) in Form eines löslichen, häufig kommerziell erhältlichen Ausgangsmaterials in einem geeigneten Lösungsmittel bereitgestellt und mit der komplexierenden, der Polymerisation zugänglichen Verbindung umgesetzt werden. Voraussetzung hierfür ist natürlich, dass die komplexierende Verbindung in der Lage ist, die Liganden des Ausgangsmaterials zu verdrängen. Dem Fachmann sind die Bindungsstärken der jeweiligen Verbindungen und Kationen bekannt, so dass hierzu keine weiteren Ausführungen nötig sind. Nur beispielhaft sei deshalb erwähnt, dass man als Ausgangsmaterialien in vorteilhafter Weise meist die Alkoxide einsetzen kann, mit Ausnahme der Bleiverbindungen, die üblicherweise in Form ihrer Acetate gelöst werden. Wenn die komplexierende Verbindung aufgrund von Faktoren, wie Chelatbildung oder thermodynamischer Begünstigung, bei der Bindungskompetition mit den Liganden des Ausgangsmaterials im Vorteil ist, kann der Austausch ohne weitere Hilfsmaßnahmen vonstattengehen; andernfalls muss gegebenenfalls das Gleichgewicht auf andere Weise verschoben werden, beispielsweise durch Einsetzen eines großen Überschusses der komplexierenden Verbindung und/oder durch Entfernen des Liganden des Vorläufermaterials durch Destillation oder durch Ausfällen oder auf andere Weise.

Die Herstellung der erfindungsgemäßen Sole kann prinzipiell analog zur Herstellung von Solen vergleichbarer Zusammensetzung erfolgen, in denen die komplexierenden Liganden keine polymerisierbare C=C-Doppelbindung aufweisen. Diesbezüglich kann beispielsweise auf DE 196 22 500 A1, DE 196 51 757 A1, DE 196 35 722 A1,
DE 199 21 261 A1, DE 10 2004 02 626 A1 oder DE 199 43 789 A1 verwiesen werden, worin die Herstellung von Solen für PZT, Aluminiumoxid, PMN, Mullit, Aluminiumoxid, Aluminium-Silicium-Mischoxid bzw. Zirkoniumoxid beschrieben ist.

Das (gegebenenfalls kommerzielle) Ausgangsmaterial, meist (mit Ausnahme von z.B. Blei, das in Form seiner Acylate eingesetzt wird) ein Alkohol, wird in einem geeigneten Lösungsmittel vorgelegt, meist einem Alkohol und häufig demselben Alkohol, der als Ligand fungiert. Werden mehrere Alkoholate aus Ausgangsmaterialien verwendet, können sie zusammen vorgelegt werden. In einem ersten Schritt können deren Liganden zur Stabilisierung des Sols gegen andere, besser komplexierende Liganden ausgetauscht werden, beispielsweise gegen chelatisierende Alkoholate. Diesbezüglich sei auf die Lehre der DE 43 32 831 C1 verwiesen. Werden neben als Alkoholate eingesetzten Metallverbindungen solche benötigt, die in anderer Form eingesetzt werden, werden diese vorzugsweise anschließend entweder ebenfalls als organische Verbindungen (z.B. Bleiacetat) oder als Hydroxid / lösliches Oxid (z.B. Bariumhydroxid) zugesetzt. Gleichzeitig oder anschließend wird die komplexierende organische Verbindung in einer Weise zugesetzt, die einerseits eine stabile Komplexbildung dieser Verbindung mit den vorhandenen Kationen ermöglicht und dabei zumindest einen Teil der Liganden der Metallverbindungen verdrängt und andererseits einer photochemischen (Additions-)Polymerisation zugänglich ist. Selbstverständlich kann es sich bei dieser komplexierenden Verbindung auch um eine Mischung von zwei oder mehr verschiedenen Verbindungen mit den genannten Eigenschaften handeln.

Durch den Austausch, den Abzug oder die Zugabe von Lösungsmittel kann das auf diese Weise erhaltene und ggf. stabilisierte Precursormaterial in dem Fachmann bekannter Weise auf die geeignete Viskosität gebracht werden. Dieses enthält nun eine oder mehrere mit zumindest teilweise photochemisch polymerisierbaren, organischen Komplexliganden komplexierte Organo(übergangs)metallverbindung(en). Die MetallKationen sind darüber hinaus über Van-der-Waals-Bindungen sowie - in der Regel - Metall-Sauerstoff-Metall-Bindungen miteinander soweit verknüpft, dass das Precursormaterial im Lösungsmittel als stabiles Sol vorliegt. Die Metall-Sauerstoff-Metall-Bindungen sind dabei meist das Resultat einer bereits teilweise erfolgten hydrolytischen Kondensation, die z.B. durch eingeschlepptes Wasser (z.B. bei Verwendung eines Ausgangsmaterials mit Kristallwasser wie Bleiacetat) oder Luftfeuchtigkeit, ggf. aber auch auf andere Weise gezielt initiiert werden kann.

Schichten, die aus diesen flüssigen Vorstufen hergestellt werden, sind direkt und durch unterschiedliche Prozesse strukturierbar. Zu diesen gehören u.a. UV-Lithographie, Laser-Direkt-Schreiben mit cw-oder Ultrakurzpulslasern (Mehr-Photonen-Absorptions-Technologie), Siebdruck, Ink-Jet-Drucken oder auch Synchrotronstrahlung. Bei ihrer Bestrahlung erfolgt eine weitere Vernetzung über die organisch polymerisierbaren Gruppen. Zur Steigerung der Vernetzbarkeit ist es möglich, die funktionalisierten Metallverbindungen mit rein organischen, durch Additionspolymerisation polymerisierbaren Monomeren zu vermischen. Diese tragen vorzugsweise mindestens zwei, häufig sogar mehr polymerisierbare Gruppen. Ebenfalls bevorzugt ist es, dass diese Gruppen dieselben oder ähnliche Gruppen sind, die die Komplexliganden tragen. Beispiele sind Trimethylolpropantriacrylat, Glycerindiacrylat oder Di(meth)acrylate, die von Bisphenol A oder Pentaerythrit abgeleitet sind.

Die UV-Lithographie und die Mehrphotonenabsorption sind für die vorliegende Erfindung die bevorzugten Strukturierungsmethoden.

Die Mehrphotonenabsorption hat dabei gegenüber der UV-Lithographie den Vorteil, dass damit auch Schichten mit der oben erwähnten 2,5-D-Struktur sowie flache, schichtförmige, dreidimensionale Strukturen und sogar in der 3. Dimension frei gestaltbare Strukturen erhalten werden können. So können Ultraschall-Arrays in Form der oben genannten 1-3-Komposite mit dieser Methode geformt werden. Dabei kann das dreidimensionale piezoelektrisch aktive Material direkt in der erforderlichen Säulenstruktur hergestellt werden, so dass sowohl Arbeitsschritte als auch Material und Energie gespart werden können. Des Weiteren sind die Anordnungen der Säulen frei wählbar, während mit einer Säge nur symmetrische Muster geschnitten werden könnten. Das erlaubt eine weitere Anpassung des Ultraschallarrays an das fertige Bauteil.

Die 3D-Strukturierbarkeit mittels Mehrphotonenpolymerisation stellt darüber hinaus eine vereinfachte Möglichkeit dar, in sich vernetzte oder sonstige Strukturen zu generieren, die sich anschließend in Oxide überführen und wie oben dargestellt verwenden lassen.

Anhand der Ausführungsformen PZT und BTO soll die Erfindung nun näher erläutert werden, ohne darauf beschränkt zu sein. Denn sie ist für die Herstellung von dünnen, aber auch dickeren strukturierten Oxidschichten und oxidischen Körpern prinzipiell geeignet, und insbesondere für solche Oxidkörper und -schichten, die spezifische, technisch relevante Funktionen erfüllen sollen, beispielsweise piezoelektrisch sein sollen. Demnach kann man selbstverständlich auch andere als die nachfolgend genannten Metallalkoxide und -acylate oder -hydroxide über das Sol-Gel-Verfahren in einer Ligandenaustauschreaktion mit polymerisierbaren Liganden umsetzen, die stabilere Komplexe als die entsprechenden Metallalkoxide bilden (oder die Komplexe mit polymerisierbaren Liganden anderweitig durch Verschieben des Reaktionsgleichgewichts erzeugen, wie oben erwähnt), zu funktionalisieren und so ein direkt strukturierbares Sol zu erhalten, das gegebenenfalls nach dem Strukturierungsschritt in einem Sinter- oder anderen Prozess in eine piezoelektrisch oder auf sonstige Weise aktive Phase überführt wird.

Zur Herstellung des Sols werden Titan- und ggf. Zirkoniumverbindungen eingesetzt, die zumindest teilweise gegen polymerisierbaren Liganden ausgetauscht werden. Geeignet sind hierfür insbesondere die Alkoxide.

In einer bevorzugten Ausführungsform der Erfindung kann auf eine Alkoholyse zu Beginn der Sol-Synthese verzichtet werden, nämlich dann, wenn bereits von Anbeginn an Ti- und Zr-Alkoxide oder dergleichen eingesetzt werden, die nicht mehr gegen einen geeigneteren Komplexliganden ausgetauscht werden müssen. Insbesondere ist es in dieser Hinsicht bevorzugt, die Isopropylate der beiden Metalle einzusetzen. Die Ti- und Zr-Alkoxide oder sonstigen Komplexverbindungen werden sodann mit dem/den erfindungsgemäßen Komplexliganden umgesetzt. Prinzipiell können alle organischen Verbindungen hierfür eingesetzt werden, die die geforderten, oben beschriebenen Eigenschaften besitzen. Günstig ist neben dem Vorhandensein der mindestens einen Doppelbindung eine Säurefunktion, da diese gut geeignet ist, die Alkoholate aus den Komplexen zu verdrängen. Auch der Chelateffekt kann für diese Aufgabe genutzt werden. Besonders geeignet sind Verbindungen, die Acrylat- und/oder Methacrylatgruppen enthalten, da diese beide Funktionen auf sich vereinigen und sich - vor allem nach Zugabe eines Photoinitiators - mit hoher Reaktionsgeschwindigkeit polymerisieren lassen.

Um die Schichtbildungseigenschaften zu verbessern, kann ein Diol, insbesondere 1,3-Propandiol als Lösungsmittel eingesetzt oder ergänzend zugesetzt werden, wie aus S. Merklein (Dissertation ISC/Universität Würzburg 1994) bekannt.

Alternativ, gleichzeitig, zuvor oder danach kann die mit dem erfindungsgemäßen Liganden umgesetzte Metallverbindung mit der/den weiteren Metallverbindungen zusammengeben werden, wenn (eine) solche vorgesehen ist, z.B. mit einer Bleiverbindung wie Bleiacetat oder mit Bariumhydroxid. Anschließend kann das Sol vorsichtig (vorzugsweise unter Normaldruck bei erhöhten Temperaturen) eingeengt werden. Dabei werden die flüchtigen Bestandteile (vorwiegend der Alkohol des eingesetzten Übergangsmetallalkoholats sowie ggf. überschüssige Acrylsäure oder dgl. und andere Bestandteile, wie z.B. Essigsäure, wenn Bleiacetat für die Bleikomponente eingesetzt wurde) entfernt, während das Diol aufgrund seiner chelatbildenden Eigenschaften als Ligand an der Metallverbindung verbleibt, sofern man das Einengen bei einer Temperatur unterhalb von dessen Siedepunkt (213°C für Propandiol) durchführt. Durch die Verwendung von Diol bleibt das Sol flüssig-viskos, so dass es nicht vor der Applikation aufgeschmolzen werden muss, wie z.B. für das eingeengte PZT-Sol in DE 43 32 831 C1 beschrieben. Die Viskosität lässt sich durch die Menge an eingesetztem Diol einstellen. Das Sol kann daher nach dem Abziehen der flüchtigen Komponenten ohne weitere Schritte als Precursormaterial eingesetzt werden. Wird auf den Zusatz eines Diols verzichtet, kann es nötig sein, das entstandene, hochviskose Sol vor der Applikation mit einem geeigneten Lösungsmittel zu verdünnen.

Das Sol ist nach seiner Herstellung lange und in geschlossenen Gefäßen auch ohne Schutzgas lagerfähig. Sobald es für die Erfindung gebraucht werden soll, wird es mit Hilfe einer gängigen Methode, beispielsweise mittels Spin- oder Dip-Coating, auf ein Substrat aufgebracht. Auf diese Weise können Schichten mit einer Schichtdicke von bis zu etwa 35µm, vorzugsweise von bis zu etwa 25 µm und ganz bevorzugt im Bereich von etwa 1-5 µm (z.B. im Bereich von etwa 2 µm), aber auch noch darüber, aus dem jeweiligen Precursor-Material, z.B. PZT- oder BTO-Solen, hergestellt werden, die mittels Licht direkt bis zu 3D strukturierbar sind. Bevorzugt ohne Photoinitiator werden photochemische Vernetzungsreaktionen für kleine Wellenlängen (im Angstrom-Bereich) initiiert. Die Strukturierung kann mit Hilfe von Ein- und Mehrphotonenprozessen (beispielsweise UV-Lithographie, Mehrphotonen-Absorption mit Ultrakurzpulslasern) erfolgen, wobei in den belichteten Bereichen organische Polymerisationsreaktionen erfolgen, während in den nicht belichteten Bereichen das Sol in organisch unvernetztem Zustand verbleibt.

Mit den in dieser Erfindung hergestellten photosensitiven Solen, insbesondere Blei-Zirkonium-Titanoxid-Solen und Barium-Titanat-Solen, können aber auch mittels direkten Strukturierungsverfahren, wie Lithographie (ohne Verwendung zusätzlicher Lift-Off-Prozesse) oder Laser-Direktschreiben mit cw- oder Ultrakurzpulslasern, strukturierte Dünnschichten erhalten werden. Auch strukturierte Dickschichten sind möglich (da es keine allgemeinverbindliche Definition für "Dick-" und "Dünnschichten" gibt, soll vorliegend folgende Einteilung verwendet werden: Eine Dicke von einer Atomlage bis 1-10nm gilt als "Dünnstschicht", der Bereich von 10nm bis 5µm gilt als Dünnschicht und Schichten mit einer Dicke von über 5µm gelten als Dickschichten). Eine Polymerisierung und Strukturierung mittels Mehr-Photonen-Absorptions-Technologie ermöglicht es dabei, neben der freien Substratwahl mit wenig Materialaufwand durch ortsselektives Verfestigen aus einer in einem Behältnis befindlichen Badflüssigkeit jegliche Art von Formen und damit auch frei gestaltbare 3D-Formkörper zu generieren, die zusätzlich mit einer individuellen Oberflächenstrukturierung versehen werden können. Eine solche Strukturierung ist bereits für andere anorganisch-organische Hybridmaterialien gezeigt worden (siehe z.B. R. Houbertz, J. Schulz, J. Serbin, B.N. Chichkov, "Schnelle Herstellung photonischer Kristalle", Phys. unserer Zeit, 36 (2005), 278-285). Mit den photosensitiven Solen der vorliegenden Erfindung können so Strukturgrößen erhalten werden, die flächig oder dreidimensional sind und die von ca. 100 nm bis in den weiten µm-Bereich, ja sogar bis in den mm- oder cm-Bereich reichen können. Die verwendbaren Wellenlängen reichen vom Angstrom- bis in den µm-Bereich.

Nach der photochemischen Strukturierung werden die Schichten oder Körper mit einem organischen Lösungsmittel gespült, in dem die komplexierten Precursor-Materialien löslich sind, beispielsweise mit Alkoholen/Diolen, wie sie für die Herstellung der erfindungsgemäß einsetzbaren Sole verwendet wurden. Nach einer meist mindestens mehrstündigen Trocknung, die eine oder mehrere Stunden, gegebenenfalls aber auch länger dauern und bei Temperaturen von Raumtemperatur bis über 100°C erfolgen kann, können die so erhaltenen strukturierten Schichten in geeigneter, bekannter Weise bei den für die jeweiligen Oxide bzw. die Ausbildung von deren spezifische Morphologie günstigen Temperaturen gesintert werden, beispielsweise bei bis zu 600°C für PZT und BTO. Durch die Sinterbedingungen werden die piezoelektrischen Eigenschaften der PZT- und BTO-Schichten kontrolliert. Dadurch wird eine Variabilität der piezoelektrischen Koeffizienten wie d₃₁ und d₃₃ gewährleistet.

Die mit der vorliegenden Erfindung erhältlichen Piezoschichten und -körper können Verwendung beispielsweise in mikroelektromechanischen Systemen (MEMS), mikrooptisch-elektromechanischen Systemen (MOEMS), Ultraschallwandlern (Transducern) oder für den Einsatz in Sensoren und Aktoren finden. Als Beispiel seien aktorische Beschichtungen von z.B. Petrischalen genannt, in denen sich Zellkulturen befinden. Diese Beschichtungen können zum direkten Ultraschall-Einkoppeln in bzw. an die Zellen dienen.

Ferroelektrische bzw. piezoelektrische Schichten können weiterhin in Form von dielektrischen Schichten bzw. Strukturen z.B. für die "Feldmodulation" (die Variation der elektrischen Feldverteilung auf Chips, Leiterplatten, in Modulen oder Systemen) oder als hinsichtlich ihrer elektrischen Eigenschaften (durch Variation des elektrischen Widerstands bzw. der elektrischen Leitfähigkeit) und damit auch hinsichtlich ihrer Wärmeleitfähigkeit steuerbare Barriereschichten sowie z.B. in Feldeffekttransistoren angewendet werden.

Nachstehend soll die Erfindung anhand von Beispielen näher erläutert werden.

### Beispiel 1 Darstellung von PZT-Sol mit Methacrylsäure als polymerisierbaren Liganden und Herstellung einer strukturierten Schicht daraus

In einem 50 ml Rundkolben wurden 6,68 g (23,5 mmol, 6,47 ml) Titanium(IV)-*n*-propylat und 14,4 g (26,5 mmol, 11,9 ml) Zirconium(IV)-*n*-propylat (70 Gew.-% in *n*-Propanol) vorgelegt. Zu dieser Mischung wurde unter Rühren langsam 7,75 g (90 mmol, 7,65 ml) Methacrylsäure getropft. Die Mischung erwärmte sich dabei leicht. Nach Abkühlen auf Raumtemperatur wurden schnell ca. 14,5 ml 1,3-Propandiol zugetropft und erneut gerührt. Zum Ti/Zr-Gemisch wurden 16,3 g (50 mmol) Blei(II)acetat-Trihydrat gegeben und die Mischung auf 80°C erhitzt, um die Bleikomponente in der Mischung zu lösen. Anschließend wurde *n*-Propanol so wie alle anderen flüchtigen Komponenten destillativ unter Normaldruck bei 130°C Ölbadtemperatur entfernt und somit ein blass gelbes, leicht viskoses Sol erhalten. Ausbeute: 43,4 g

21,0 g des so erhaltenen PZT-Sols wurden mit 0,21 g (66,4 mmol, 1 Gew.-%) Lucirin TPO-L versetzt und über Nacht gerührt. Anschließend wurde die Mischung drei Tage stehen gelassen, um etwaige Blasen aus der Reaktionsmischung entweichen zu lassen. Das Sol wurde mittels Spincoating mit 7500 rpm 90s lang auf das Substrat aufgeschleudert. Die erhaltene Mischung wurde anschließend mit einem Maskaligner (365 nm ± Δ λ) 60 s lang photochemisch strukturiert. Anschließend wurden die Strukturen mit einem organischen Lösemittelgemisch entwickelt, indem die unbelichteten Bereiche weggespült wurden.

Die Sinterung der Schichten erfolgte ab Raumtemperatur bis 600 bzw. 700°C, nachdem sie zuvor 15 h bei 110 °C getrocknet wurden.

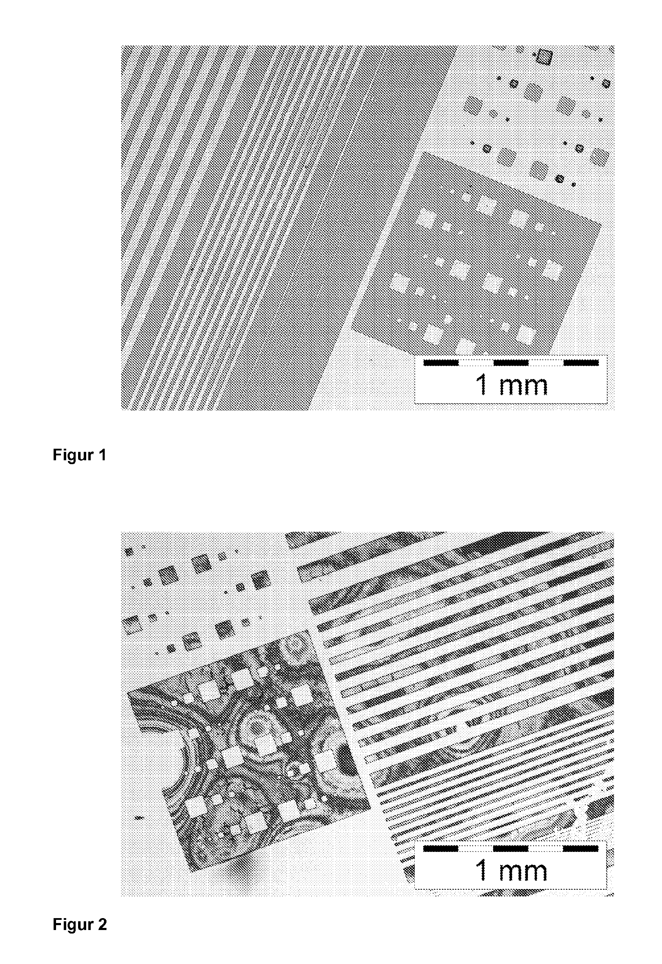

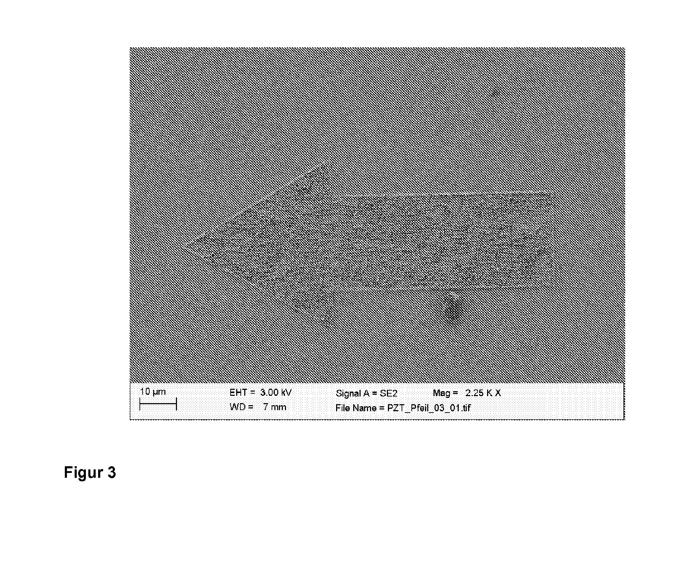

**Figur 1** ist die Lichtmikroskopaufnahme von PZT-Solen, die mittels UV-Lithographie (Belichtung, Entwicklung) hergestellt wurden. **Figur 2** ist eine rasterelektronische Mikroskopaufnahme von PZT-Sol-Strukturen, die mittels Zwei-Photonen-Polymerisation hergestellt und einem nachfolgenden Entwicklungsschritt unterzogen wurden.

### Beispiel 2 Darstellung von Mischung aus PZT-Sol mit Methacrylsäure als polymerisierbaren Liganden und Trimethylolpropantriacrylat (TMPTA) als polymerisierbarem Monomer und Herstellung einer strukturierten Schicht daraus

Das PZT-Sol wurde analog zu Beispiel 1 dargestellt. Anschließend wurden zu 1,0 g PZT-Sol (ca. 1,2 mmol Ti+Zr) 0,22 g (0,7 mmol) TMPTA zugegeben und über Nacht gerührt. Das Verhältnis entspricht ca. 0,6 mol TMPTA pro mol Zirkonium- und Titankomplexe. Anschließend wurde zur PZT-Sol/Monomer-Mischung 0,05 g (0,15 mmol, ca. 4 Gew.-%) Lucirin TPO-L gegeben, die Mischung über Nacht gerührt und anschließend drei Tage stehengelassen.

Die so erhaltene Mischung aus PZT-Sol, Monomer und Photo-Initiator wurde mittels Spincoating mit 7500 rpm 90s lang auf das Substrat aufgeschleudert und anschließend mit einem Maskaligner (365 nm ± Δ λ) 60 s lang photochemisch strukturiert. Anschließend wurden die Strukturen mit einem organischen Lösemittelgemisch entwickelt, indem die unbelichteten Bereiche weggespült wurden.

Nach einer Trocknung bei 110 °C für 15 h erfolgte die Sinterung der Schichten ab Raumtemperatur bis 600°C.

### Beispiel 3 Darstellung von BTO-Sol mit Methacrylsäure als polymerisierbaren Liganden und Herstellung einer strukturierten Schicht daraus

In einem 50 ml Rundkolben wurden 7,59 g (44,1 mmol) Bariumhydroxid-Monohydrat vorgelegt und in 34,4 g (573 mmol, 32,8 ml) Eisessig gelöst. In einem weiteren 50 ml Rundkolben wurden 15,0 g (44,1 mmol, 15,0 ml) Titanium(IV)-n-butylat vorgelegt und unter Rühren langsam 7,59 g (88,2 mmol, 7,50 ml) Methacrylsäure zugetropft. Die Mischung erwärmte sich dabei leicht. Nach Abkühlen auf Raumtemperatur wurden die Ti-Methacrylsäure-Lösung zur Ba-Lösung gegeben und ca. 30 min bei Raumtemperatur gerührt. Anschließend wurden die flüchtigen Komponenten destillativ im Vakuum bei 40°C Ölbadtemperatur entfernt und somit ein gelbes, viskoses Sol erhalten. Ausbeute: 33,0 g.

21,0 g des so erhaltenen PZT-Sols wurden mit 0,21 g (66,4 mmol, 1 Gew.-%) Lucirin TPO-L versetzt und über Nacht gerührt. Anschließend wurde die Mischung drei Tage stehengelassen, um etwaige Blasen aus der Reaktionsmischung entweichen zu lassen. Das Sol wurde mittels Spincoating mit 7500 rpm 30 s lang auf das Substrat aufgeschleudert. Die erhaltene Mischung wurde anschließend mit einem Maskaligner (365 nm ± Δ λ) 60 s lang photochemisch strukturiert.

Die Sinterung der Schichten erfolgte ab Raumtemperatur bis 700°C (Haltezeit 1 h), nachdem sie zuvor 15 h bei 110 °C getrocknet wurden.

### Beispiel 4 Darstellung von PZT-Sol mit Methacrylsäure als polymerisierbarem Liganden und Essigsäure als zusätzlichem nicht polymerisierbarem Liganden und Herstellung einer strukturierten Schicht daraus

In einem 50 ml Rundkolben wurden 2,67 g (7,83 mmol, 2,37 ml) Titanium(IV)-*n*-butylat und 4,24 g (8,83 mmol) Zirconium(IV)-*n*-butylat (80 Gew.-% in *n*-Butanol) vorgelegt. Zu dieser Mischung wurde unter Rühren langsam 2,58 g (30 mmol, 2,55 ml) Methacrylsäure getropft. Die Mischung erwärmte sich dabei leicht. Nach Abkühlen auf Raumtemperatur wurden schnell ca. 4,75 ml 1,3-Propandiol zugetropft und erneut gerührt. Zum Ti/Zr-Gemisch wurden 6,95 g (18,3 mmol) Blei(II)acetat-Trihydrat gegeben und die Mischung auf 80°C erhitzt, um die Bleikomponente in der Mischung zu lösen. Anschließend wurde *n*-Butanol so wie alle anderen flüchtigen Komponenten destillativ unter reduziertem Druck (21-61 mbar) bei 55-65°C Ölbadtemperatur entfernt und somit ein blass gelbes, leicht viskoses Sol erhalten. Ausbeute: 14,29 g

### Das Sol wurde mit 0,636 g (0,606 ml, 10,6 mmol) Essigsäure versetzt und gerührt. Anschließend wurde die Mischung mit 3,72 g (4,59 ml) n-Butanol versetzt und so ein Feststoffgehalt von 31 % eingestellt.

4,98 g des so erhaltenen PZT-Sols wurden mit 0,02 g (6,32 mmol, 2 Gew.-%) Lucirin TPO-L versetzt und über Nacht gerührt. Die Mischung wurde drei Tage stehen gelassen, um etwaige Blasen aus der Reaktionsmischung entweichen zu lassen und abschließend filtriert um mögliche feste Bestandteile zu entfernen. Das Sol wurde mittels Spincoating mit 6000 rpm 30 s lang auf das Substrat aufgeschleudert. Die erhaltene Mischung wurde anschließend mit einem Maskaligner (365 nm ± Δ λ) 60 s photochemisch strukturiert. Anschließend wurden die Strukturen mit einem organischen Lösemittelgemisch entwickelt, indem die unbelichteten Bereiche weggespült wurden.

Die Sinterung der Schichten erfolgte ab Raumtemperatur oder ab 500 °C bis maximal 700°C, nachdem sie zuvor 1 h bei 110 °C getrocknet und teilweise bei 360 °C für 10 min. vorgesintert wurden.

### Beispiel 5 Herstellung eines Körpers mit Hilfe von Zwei- oder Mehrphotonenpolymerisation

Mit einer auf dem Prinzip der Mehrphotonenpolymerisation beruhenden Vorrichtung, wie sie aus dem Stand der Technik bekannt ist, ist es möglich, dreidimensionale Strukturen ohne zusätzliche Arbeitsschritte, wie zum Beispiel Ätzen, herzustellen. Hierzu wird ein fokussierter Ultrakurzpulslaser verwendet, der das zu strukturierende Material zeilen- und schichtweise abrastert und so durch den Laserfokus eine räumlich definierte Polymerisation hervorruft.

Als zu strukturierendes Material wurde in diesem Beispiel das mit 1,5 Gewichtsprozent Photostarter Lucirin TPO-L versetzte PZT-Sol aus Beispiel 4 verwendet, das jedoch nicht mit n-Butanol auf 31 Gewichtsprozent, sondern mit 4,75 ml 1,3-Propandiol und 3 ml Propylenglycolmonomethyletheracetat auf 25 Gewichtsprozent verdünnt wurde. Anschließend wurde es in ein Bad eingefüllt und mit Hilfe der Vorrichtung derart mit einem Fokus bestrahlt, dass nur die im Fokus der Strahlung liegenden Volumenelemente (Voxel) im Bad verfestigt wurden, nicht aber das Material, das die Strahlung auf dem Weg dorthin durchläuft. Für Schichten und in der Höhe sehr kleine dreidimensionale Flächen kann als "Bad" bereits eine Schicht des Materials zwischen einem Substrat, z.B. einem ersten Gläsplättchen, und einem zweiten Glasplättchen dienen, die je nach Bedarf z.B. einen Abstand im Bereich von 0,2 bis 3 mm zueinander haben. Größere Strukturen werden in einem Materialbad-Behälter erzeugt. Dabei dient entweder der Behälterboden oder ein darin befindlicher Träger als Substrat, an dem die ersten verfestigten Volumenelemente haften. Für quaderförmige Strukturen mit einer Kantenlänge von 10 µm wurde eine Schreibgeschwindigkeit von 20 µm/s und Belichtungsleistungen von 6-15 mW in Kombination mit einem 100fach Immersionsöl-Objektiv mit einer numerischen Apertur von 1,4 verwendet. Nach der Belichtung des Materials wurde das nicht polymerisierte und somit nicht verfestigte PZT-Sol in einem Entwicklungsschritt analog zu Beispiel 4 entfernt und schließlich mit 4-Methyl-2-pentanon gespült.

## Patentansprüche

1. Verfahren zum Herstellen eines strukturierten Formkörpers oder einer solchen Schicht aus einem Precursor für ein Oxid oder Mischoxid eines oder mehrerer Metalle, ausgewählt unter Magnesium, Strontium, Barium, Aluminium, Gallium, Indium, Silicium, Zinn, Blei und den Übergangsmetallen, umfassend die Schritte:
(a) Lösen mindestens einer Verbindung des einen oder mehrerer Metalle in einem organischen Lösungsmittel und/oder Austauschen eines Liganden der bzw. einer der gelösten Metallverbindung(en) gegen einen stabilisierenden Liganden,
(b) Zusetzen eines Liganden zu der Lösung, der mindestens eine photochemisch polymerisierbare Gruppe und mindestens eine solche Gruppe aufweist, die eine stabile Komplexbildung ermöglicht, und Ausbilden eines Sols mit oder aus dem Produkt dieser Reaktion (Precursor),
(c) Aufbringen des Sols auf ein Substrat,
(d) Anisotropes Belichten des Sols derart, dass in den belichteten Bereichen eine Polymerisation photochemisch polymerisierbarer Gruppen stattfindet,
wobei das Sol in Schritt (c) in strukturierter Form aufgetragen wird und/oder die nicht belichteten Bereiche des Sols nach der Polymerisation unter Zurückbleiben des Formkörpers oder der strukturierten Schicht entfernt werden,
**dadurch gekennzeichnet, dass** Schritt (b) entweder ohne weitere Hilfsmaßnahmen erfolgt oder dass dieser Schritt unter Durchführung einer Maßnahme durchgeführt wird, durch welche das Gleichgewicht zur Produktseite hin verschoben wird.

2. Verfahren zum Herstellen eines strukturierten Formkörpers oder einer solchen Schicht aus einem Oxid oder Mischoxid eines oder mehrerer Metalle, ausgewählt unter Magnesium, Strontium, Barium, Aluminium, Gallium, Indium, Silicium, Zinn, Blei und den Übergangsmetallen, umfassend die Schritte:
(a) Lösen mindestens einer Verbindung des einen oder mehrerer Metalle in einem organischen Lösungsmittel und/oder Austauschen eines Liganden der bzw. einer der gelösten Metallverbindung(en) gegen einen stabilisierenden Liganden,
(b) Zusetzen eines Liganden zu der Lösung, der mindestens eine photochemisch polymerisierbare Gruppe und mindestens eine solche Gruppe aufweist, die eine stabile Komplexbildung ermöglicht, und Ausbilden eines Sols mit oder aus dem Produkt dieser Reaktion (Precursor),
(c) Aufbringen des Sols auf ein Substrat,
(d) Anisotropes Belichten des Sols derart, dass in den belichteten Bereichen eine Polymerisation photochemisch polymerisierbarer Gruppen stattfindet, wobei das Sol in Schritt (c) in strukturierter Form aufgetragen wird und/oder die nicht belichteten Bereiche des Sols nach der Polymerisation unter Zurückbleiben des Formkörpers oder der strukturierten Schicht entfernt werden, und
(e) Sintern des Formkörpers oder der Schicht, bis die organischen Bestandteile entfernt sind.

3. Verfahren nach Anspruch 1 oder 2, **dadurch gekennzeichnet, dass** es sich bei der Polymerisation um eine Additionspolymerisation handelt.

4. Verfahren nach einem der voranstehenden Ansprüche, **dadurch gekennzeichnet, dass** das Metall/die Metalle ausgewählt ist/sind unter Aluminium, Zirkonium, der II., III., IV. und V. Nebengruppe sowie aus einer Kombination von Metallen, ausgewählt unter Titan, Zirkonium, Blei, Barium und Strontium, deren Mischoxid nach geeigneter Aktivierung ein piezoelektrisches oder magnetisches Verhalten zeigen.

5. Verfahren nach einem der voranstehenden Ansprüche, **dadurch gekennzeichnet, dass** mindestens eine Metallverbindung ein Alkoxid ist und in einem Alkohol gelöst wird oder dass zwei oder mehr Verbindungen von Metallen als Alkoxide vorliegen und in ein- und demselben Alkohol gelöst werden.

6. Verfahren nach Anspruch 5, **dadurch gekennzeichnet, dass** ein weiteres Metall, das nicht als Alkoxid vorliegt, in Form seines Acylats oder Hydroxids entweder separat gelöst oder in fester Form der bereits mit dem Liganden gemäß Schritt (b) versetzten Lösung des/der Metalle zugesetzt wird.

7. Verfahren nach einem der voranstehenden Ansprüche, **dadurch gekennzeichnet, dass** der Lösung ein Diol zugesetzt wird.

8. Verfahren nach einem der voranstehenden Ansprüche, **dadurch gekennzeichnet, dass** der Lösung ein rein organisches Vernetzungsmittel zugesetzt wird, das mit den photochemisch polymerisierbaren Gruppen des unter (b) definierten Liganden copolymerisierbar ist.

9. Verfahren nach einem der Ansprüche 1 bis 8, **dadurch gekennzeichnet, dass** das anisotrope Belichten ein Belichten mit Hilfe der Zwei- oder Mehrphotonen-Absorption ist oder umfasst.

10. Verfahren nach Anspruch 9, **dadurch gekennzeichnet, dass** das anisotrope Belichten in einem Bad aus dem Precursor-Sol erfolgt, worin infolge einer Zwei- oder Mehrphotonen-Additionspolymerisation eine ortsselektive Verfestigung des Precursor-Sols zu einem dreidimensionalen Formkörper stattfindet.

11. Verfahren nach einem der Ansprüche 1 bis 8, **dadurch gekennzeichnet, dass** das Sol in Schritt (c) mit Hilfe von Siebdruck oder Ink-Jet-Druck in strukturierter Form aufgetragen wird.

12. Verfahren nach einem der voranstehenden Ansprüche, **dadurch gekennzeichnet, dass** die photochemisch aktivierbare Gruppe unter Acrylat und Methacrylat ausgewählt ist und/oder dass die Gruppe, die eine stabile Komplexbildung ermöglicht, ausgewählt ist unter Carboxylatgruppen und 1,3-Diketonen ausgewählt ist.

13. Verfahren nach Anspruch 2 oder einem davon abhängigen Anspruch, **dadurch gekennzeichnet, dass** die eingesetzten Metallverbindungen solche des Blei, des Zirkoniums und des Titans oder des Bariums und des Titans sind und der gemäß Schritt (f) erhaltene Körper bzw. die gemäß diesem Schritt erhaltene Schicht polarisiert wird, derart, dass ein piezoelektrischer Formkörper / eine piezoelektrische Schicht entsteht.

14. Geformter Körper oder auf einem Substrat befindliche, strukturierte Schicht, enthaltend mehrere Metallkationen, ausgewählt aus der Gruppe, die aus Titan, Zirkonium, Blei, Barum und Strontium in einer Kombination, die nach Überführung in die entsprechenden Oxide piezoelektrisches Verhalten zeigt, einer Kombination aus Blei, Magnesium und Niob und einer Kombination aus Aluminium und Silicium in einem Mengenverhältnis besteht, das die Ausbildung von Mullit erlaubt, sowie mindestens einen anionischen Komplexliganden, der mindestens eine solche Gruppe aufweist, die eine stabile Komplexbildung zu mindestens einem der Metallkationen ausbildet, **dadurch gekennzeichnet, dass** der Ligand weiterhin mindestens eine Gruppe aufweist, die infolge photochemischer Polymerisation in einer Verknüpfung aus organischen, linearen oder vernetzten Strukturen eingebunden vorliegt.

15. Geformter Körper oder auf einem Substrat befindliche, strukturierte Schicht nach Anspruch 14, worin die Metallkationen ausgewählt sind aus einer Kombination von Barium und Titan sowie von Blei, Zirkonium und Titan und worin in die organische Verknüpfung aus linearen oder vernetzten Strukturen rein organische Dimere oder höhere Oligomere einpolymerisiert sind.

## Claims

1. Process for manufacturing a structured shaped body or a structured layer from a precursor for an oxide or mixed oxide of one or several metals, selected from magnesium, strontium, barium, aluminum, gallium, indium, silicon, tin, lead and the transition metals, comprising the steps:
(a) dissolving at least one compound of the one or several metals in an organic solvent and/or exchanging a ligand of the or one of the dissolved metallic compound(s) for a stabilizing ligand,
(b) adding a ligand to the solution that has at least one photochemically polymerizable group and at least one such group that allows a stable complex formation, and forming a sol with or from the product of this reaction (precursor),
(c) applying the sol onto a substrate,
(d) irradiating the sol anisotropically with light in such a way that in the irradiated areas, a polymerization of the photochemically polymerizable groups takes place,
wherein the sol in step (c) is applied in structured form and/or the non-irradiated areas of the sol are removed after polymerization while the shaped body or the structured layer remains,
**characterized in that** step (b) takes place either without additional supporting measures or in that this step is carried out by using a measure through which the equilibrium is shifted towards the product side.

2. Process for manufacturing a structured shaped body or a structured layer from an oxide or mixed oxide of one or several metals, selected from magnesium, strontium, barium, aluminum, gallium, indium, silicon, tin, lead and the transition metals, comprising the steps:
(a) dissolving at least one compound of the one or several metals in an organic solvent and/or exchanging a ligand of the or one of the dissolved metallic compound(s) for a stabilizing ligand,
(b) adding a ligand to the solution that has at least one photochemically polymerizable group and at least one such group that allows a stable complex formation, and forming a sol with or from the product of this reaction (precursor),
(c) applying the sol onto a substrate,
(d) irradiating the sol anisotropically with light in such a way that in the irradiated areas, a polymerization of the photochemically polymerizable groups takes place,
wherein the sol in step (c) is applied in structured form and/or the non-irradiated areas of the sol are removed after polymerization while the shaped body or the structured layer remains, and
(e) sintering the shaped body or the layer until the organic components are removed.

3. Process according to claim 1 or 2, **characterized in that** the polymerization is an addition polymerization.

4. Process according to any of the preceding claims, **characterized in that** the metal/the metals is/are selected from aluminum, zirconium, the II., III., IV. and V. subgroup and from a combination of metals, selected from titanium, zirconium, lead, barium and strontium, whose mixed oxide show piezoelectric or magnetic behavior after appropriate activation.

5. Process according to any of the preceding claims, **characterized in that** at least one metal compound is an alkoxide and is dissolved in an alcohol, or that two or more metal compounds are present as alkoxides and are dissolved in one and the same alcohol.

6. Process according to claim 5, **characterized in that** an additional metal, not present in the form of an alkoxide, is added in the form of its acylate or hydroxide either separately dissolved or in solid form to the solution of the metal(s) already provided with the ligand according to step (b).

7. Process according to any of the preceding claims, **characterized in that** a diol is added to the solution.

8. Process according to any of the claims 1 to 8, **characterized in that** a purely organic crosslinking agent is added to the solution that is co-polymerizable with the photochemically polymerizable groups of the ligand defined in (b).

9. Process according to any of the preceding claims, **characterized in that** the anisotropic irradiation with light is or comprises an irradiation by means of two- or multi-photon absorption.

10. Process according to claim 9, **characterized in that** the anisotropic irradiation is performed in a bath of the precursor sol wherein, as a result of a two- or multi-photon addition polymerization, a site-selective solidification of the precursor sol to a three-dimensional shaped body takes place.

11. Process according to any of claims 1 to 8, **characterized in that** the sol is applied in step (c) in structured form by means of screen printing or ink jet printing.

12. Process according to any of the preceding claims, **characterized in that** the group that can be photochemically activated is selected from acrylate and methacrylate and/or that the group that allows a stable complex formation to take place is selected from carboxylate groups and 1,3-diketones.

13. Process according to claim 2 or a claim depending on it, **characterized in that** the metal compounds used are those of lead, zirconium and titanium or of barium and titanium and that the body obtained according to step (f) or the layer obtained according to this step is polarized in such a way that a piezoelectric shaped body / a piezoelectric layer is formed.

14. Shaped body or structured layer situated on a substrate, containing a plurality of metal cations, selected from the group consisting of titanium, zirconium, lead, barium and strontium in a combination that, after conversion into the corresponding oxides, shows piezoelectric behavior, a combination of lead, magnesium and niobium, and a combination of aluminum and silicon in a proportion that allows the formation of mullite, and at least one anionic complex ligand comprising at least one such group that forms a stable complex formation to at least one of the metal cations, **characterized in that** the ligand furthermore comprises at least one group which, as a result of photochemical polymerization, is present in a form incorporated into a network of organic, linear or cross-linked structures.

15. Shaped body or structured layer situated on a substrate according to claim 14, wherein the metal cations are selected from a combination of barium and titanium as well as of lead, zirconium and titanium and wherein purely organic dimers or higher oligomers have been polymerized into the organic network made up of linear or cross-linked structures.

## Revendications

1. Procédé de production d'un article formé structuré ou d'une telle couche à partir d'un précurseur d'un oxyde ou d'un oxyde mixte d'un ou de plusieurs métaux, choisis parmi le magnésium, le strontium, le baryum, l'aluminium, le gallium, l'indium, le silicium, l'étain, de plomb et les métaux de transition, comprenant les étapes consistant à:
a) dissoudre au moins un composé du ou desdits métaux dans un solvant organique et/ou échanger un ligand du ou d'un des composé(s) métallique(s) dissous contre un ligand stabilisateur,
b) ajouter à la solution un ligand, qui contient au moins un groupe polymérisable par voie photochimique et au moins un tel groupe permettant une complexation stable, et former un sol avec ou à partir du produit de cette réaction (précurseur),
c) déposer le sol sur un substrat,
d) insoler le sol en conditions anisotropes de façon à déclencher dans les zones insolées une polymérisation des groupes polymérisables par voie photochimique,
le sol étant déposé à l'étape (c) sous une forme structurée et/ou les zones non insolées du sol étant éliminées après la polymérisation pour laisser l'article formé ou la couche structurée,
**caractérisé en ce que** soit on exécute l'étape (b) sans autres mesures auxiliaires soit on exécute cette étape en mettant en oeuvre une mesure par laquelle l'équilibre est déplacé vers le côté du produit.

2. Procédé de production d'un article formé structuré ou d'une telle couche à partir d'un oxyde ou d'un oxyde mixte d'un ou de plusieurs métaux, choisis parmi le magnésium, le strontium, le baryum, l'aluminium, le gallium, l'indium, le silicium, l'étain, de plomb et les métaux de transition, comprenant les étapes consistant à:
a) dissoudre au moins un composé du ou desdits métaux dans un solvant organique et/ou échanger un ligand du ou d'un des composé(s) métallique(s) dissous contre un ligand stabilisateur,
b) ajouter à la solution un ligand, qui contient au moins un groupe polymérisable par voie photochimique et au moins un tel groupe permettant une complexation stable, et former un sol avec ou à partir du produit de cette réaction (précurseur),
c) déposer le sol sur un substrat,
d) insoler le sol en conditions anisotropes de façon à déclencher dans les zones insolées une polymérisation des groupes polymérisables par voie photochimique,
le sol étant déposé à l'étape (c) sous une forme structurée et/ou les zones non insolées du sol étant éliminées après la polymérisation pour laisser l'article formé ou la couche structurée, et
e) fritter l'article formé ou la couche, jusqu'à ce que les constituants organiques aient été éliminés.

3. Procédé selon la revendication 1 ou 2, **caractérisé en ce que** la polymérisation est une polymérisation par addition.

4. Procédé selon l'une quelconque des revendications précédentes, **caractérisé en ce que** le métal/les métaux est/sont choisi(s) parmi l'aluminium, le zirconium, le sous-groupe II, III, IV et V ainsi que parmi une combinaison de métaux choisis parmi le titane, le zirconium, le plomb, le baryum et le strontium, dont les oxydes mixtes présentent après une activation adéquate un comportement piézoélectrique ou magnétique.

5. Procédé selon l'une quelconque des revendications précédentes, **caractérisé en ce qu'**au moins un composé métallique est un alcoxyde et est dissous dans un alcool ou **en ce que** deux composés ou plus de métaux sont présents sous forme d'alcoxydes et sont dissous dans un seul et même alcool.

6. Procédé selon la revendication 5, **caractérisé en ce qu'**un autre métal, qui n'est pas présent sous forme d'alcoxyde, est ou bien dissous séparément sous la forme de son acylate ou de son hydroxyde ou bien ajouté sous forme solide à la solution du métal/des métaux déjà mélangée avec le ligand selon l'étape (b).

7. Procédé selon l'une quelconque des revendications précédentes, **caractérisé en ce que** l'on ajoute un diol à la solution.

8. Procédé selon l'une quelconque des revendications précédentes, **caractérisé en ce que** l'on ajoute à la solution un agent de réticulation purement organique, qui est copolymérisable avec les groupes polymérisables par voie chimique du ligand défini sous (b).

9. Procédé selon l'une quelconque des revendications 1 à 8, **caractérisé en ce que** l'insolation en conditions anisotropes est ou comprend une insolation à l'aide de l'absorption à deux photons ou à plusieurs photons.

10. Procédé selon la revendication 9, **caractérisé en ce que** l'insolation en conditions anisotropes est effectuée dans un bain du sol de précurseur, dans lequel il se produit une solidification locale sélective du sol de précurseur en un article formé tridimensionnel par suite d'une polymérisation par addition à deux photons ou à plusieurs photons.

11. Procédé selon l'une quelconque des revendications 1 à 8, **caractérisé en ce que** le sol est déposé sous forme structurée à l'étape (c) à l'aide d'une opération d'impression par sérigraphie ou d'impression à jet d'encre.

12. Procédé selon l'une quelconque des revendications précédentes, **caractérisé en ce que** le groupe activable par voie photochimique est choisi parmi l'acrylate et le méthacrylate et/ou **en ce que** le groupe, qui permet une complexation stable, est choisi parmi les groupes carboxylate et les 1,3-dicétones.

13. Procédé selon la revendication 2 ou une revendication qui en dépend, **caractérisé en ce que** les composés métalliques utilisés sont des composés du plomb, du zirconium et du titane ou du baryum et du titane et l'article obtenu suivant l'étape (f) ou la couche obtenue suivant cette étape est polarisé(e) de telle manière qu'il apparaisse un article piézoélectrique / une couche piézoélectrique.

14. Article formé ou couche structurée se trouvant sur un substrat, contenant plusieurs cations métalliques, choisis dans le groupe, qui se compose du titane, du zirconium, du plomb, du baryum et du strontium en une combinaison qui, après conversion dans les oxydes correspondants, présente un comportement piézoélectrique, une combinaison de plomb, de magnésium et de niobium et une combinaison d'aluminium et de silicium en un rapport de mélange, qui permet la formation de mullite, ainsi qu'au moins un liant complexant anionique, qui présente au moins un groupe formant une complexation stable avec au moins un des cations métalliques, **caractérisé en ce que** le ligand présente en outre au moins un groupe qui, par suite d'une polymérisation photochimique, est présent sous forme liée dans une liaison composée de structures organiques, linéaires ou réticulées.

15. Article formé ou couche structurée se trouvant sur un substrat selon la revendication 14, dans lequel/laquelle les cations métalliques sont choisis parmi une combinaison de baryum et de titane ainsi que de plomb, de zirconium et de titane et dans lequel/laquelle des dimères ou des oligomères plus élevés purement organiques sont polymérisés dans la liaison organique de structures linéaires ou réticulées.
